(19)

Europäisches
Patentamt
European
Patent Office
Office européen
des brevets

(11)   **EP 1 788 701 A1**

(12)   **EUROPEAN PATENT APPLICATION**

(43) Date of publication:
**23.05.2007 Bulletin 2007/21**

(51) Int Cl.:
*H03F 3/217* $^{(2006.01)}$

(21) Application number: **05425811.6**

(22) Date of filing: **17.11.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **STMicroelectronics S.r.l.**
**20041 Agrate Brianza (Milano) (IT)**

(72) Inventors:
• **Guanziroli, Federico**
**20030 Lentate sul Seveso (Milano) (IT)**

• **Nicollini, Germano**
**29100 Piacenza (IT)**
• **Confalonieri, Pierangelo**
**20040 Caponago (Milano) (IT)**

(74) Representative: **Siniscalco, Fabio et al**
**Jacobacci & Partners S.p.A.**
**Via Senato, 8**
**20121 Milano (IT)**

(54)   **Class-D audio amplifier**

(57)     An open-loop class-D amplifier (300) comprises a generation device (307) of a triangular wave signal ($v_{tri}$(t)) having a differential output. Furthermore, the amplifier comprises at least one comparing circuit (302) provided with first differential input terminals (S+,S-) in order to receive a first signal ($v_{in}$(t)) and second differential input terminals (T+,T-) in order to receive the triangular signal. In addition, the amplifier comprises a power stage (300')
in order to give an output signal ($v_{out}$(t)) to a load (306) and a terminal connectable to a power supply potential ($V_A$).

The amplifier is characterized in that the generation device is such that the triangular signal has a peak value ($V_{tri}$) which is substantially proportional to said power supply potential ($V_A$) and a frequency ($f_{fri}$) which is fixed to a reference frequency value ($f_{ck}$), for the power supply potential changes.

FIG.2

EP 1 788 701 A1

## Description

The present invention relates to electronic amplifying devices, particularly the invention relates to an audio amplifier of the class-D-type.

In recently devised electronic amplifiers, particularly in audio amplifiers usable in battery-operated portable devices, the need for introducing output stages of the class-D type instead of the conventional class-AB output stages is felt.

As it is known to those skilled in the art, the class-D output stages comprise at least one N-MOS transistor and one P-MOS transistor having their respective gate and drain terminals connected to each other in an inverter configuration. Furthermore, these transistors act as a switch in order to alternately take either an ON or OFF state. Particularly, when one of these transistors is OFF (and the other one is ON) the current passing through it is equal to zero, whereas when this transistor is ON (and the other one is OFF) the voltage drop on it is slight, ideally null.

In any case, the non-simultaneous ON condition of the transistors of the output stage of a class-D amplifier (if the short time intervals during the ON-OFF switching are excluded) ensures a reduced power dissipation. Therefore, the class-D amplifier has an efficiency which is higher than that of a class-AB one under the same output power given to a load.

In addition, the reduced power dissipation of the class-D amplifier ensures a longer life of the power supply batteries in the portable devices, as well as a reduced overall overheating of the amplifier integrated circuit and an increase in the reliability of the same.

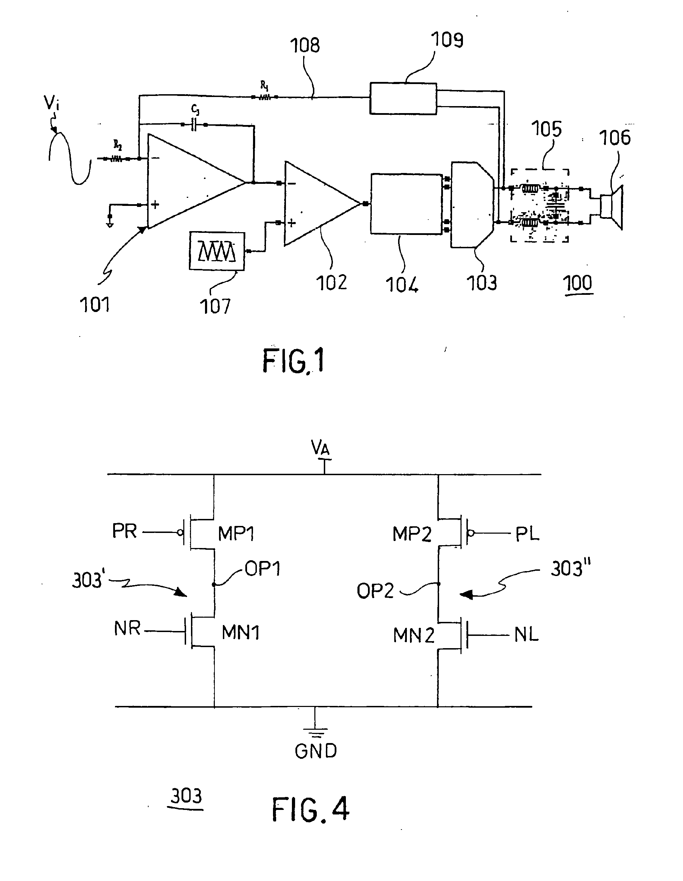

Generally, closed-loop class-D amplifiers are used for audio applications. For example, a circuit block diagram of a closed-loop class-D amplifier 100 of the known type is shown in Fig. 1.

Particularly, the amplifier 100 comprises an integrating circuit 101, on a main or "input" line of a feedback loop, in order to receive an input audio signal $v_i$, a comparator 102, a class-D output stage 103 controllable by a driving circuit 104. Moreover, the amplifier 100 comprises an output low-pass filter 105 of the LC-type connected to a loudspeaker 106. It shall be noted that an output of the integrator 101 is connected to an inverting terminal (-) of the comparator 102, whereas the other non-inverting terminal (+) is connected to a triangular wave generator 107.

Furthermore, a differential signal picked up downstream of the output stage 103 is brought back to the input of the integrating circuit 101 as a single-ended signal by means of a feedback line 108 comprising an attenuation and filtering block 109 and a resistance $R_1$.

It shall be noted that this amplifier 100 is of the binary type, i.e. the differential signal picked up downstream of the output stage 103 only takes two levels.

For audio applications, class-D amplifiers of the ternary type in which the output signal may take three levels are also used.

It shall be noted that the closed-loop audio amplifier 100 from Fig. 1 ensures a high Power Supply Rejection Ratio or PSRR and a reduction in the introduced distortion of the non-ideal conditions of the output stage 103. Moreover, as it is known to those skilled in the art, the low-frequency gain of this amplifier is well defined and stable, being equal to $G_1 = -R_1/R_2$.

However, as it is known, an audio signal takes low voltage levels for most of the time, therefore the audio amplifiers should ensure a high efficiency for these low levels. This does not occur in the closed-loop class-D amplifier 100, the efficiency of which for low voltage levels is reduced due to static power dissipation and switching dissipation (due to the charge and discharge of the capacitors on the amplifier output nodes).

It is also known that a class-D audio amplifier of the open-loop type may ensure a higher efficiency for low voltage levels compared to the closed-loop amplifier 100. However, this open-loop amplifier does not ensure gain stability and an adequate PSRR for audio applications.

The object of the present invention is to provide an amplifier of the class-D type, particularly an open-loop one, which overcomes the drawbacks and limits of the known amplifiers.

This object is achieved by a class-D amplifier such as described in the annexed claim 1.

Alternative embodiments of the amplifier of the invention are indicated in the dependent claims.

The characteristics and the advantages of the present invention will be better understood from the following detailed description of one embodiment thereof, which is given by way of illustrative and non-limiting example with reference to the annexed drawings, in which:

- Fig. 1 shows a circuit block diagram of a class-D amplifier of the known type;
- Fig. 2 shows a circuit block diagram of an open-loop class-D amplifier in accordance with the present invention;
- Fig. 3 shows a circuit block diagram of a further open-loop class-D amplifier in accordance with the present invention;
- Fig. 4 shows a circuit diagram of a class-D output stage of the amplifiers of Figs. 2 and 3;
- Fig. 5 shows an exemplary embodiment of a triangular signal generation device which can be used in the amplifiers of Figs. 2 and 3;

- Fig. 6 shows a logic circuit associable to the generation device of Fig. 5.

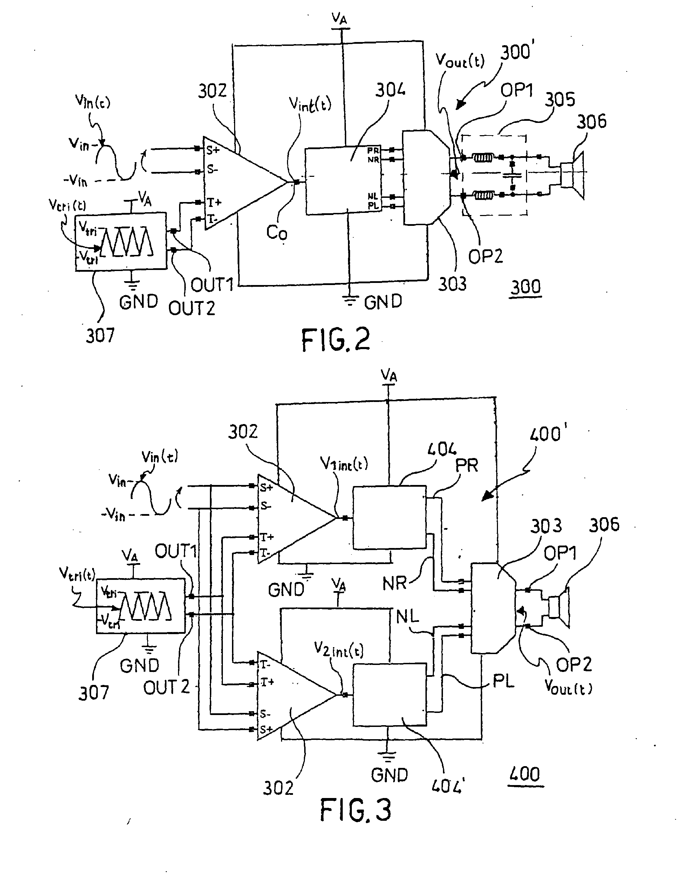

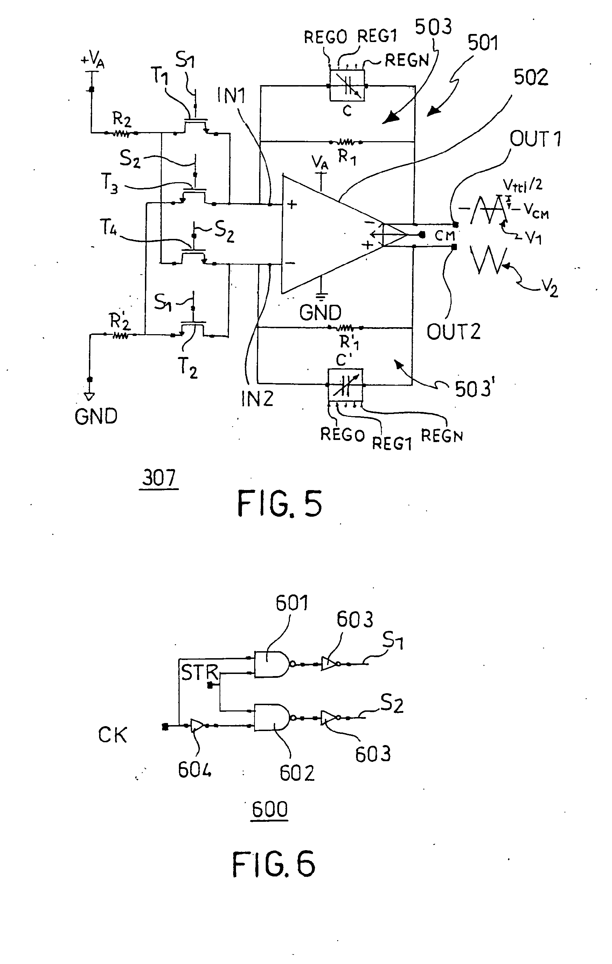

A circuit block diagram of a class-D amplifier 300 in accordance with the invention can be described with reference to Figs. 2 and 4.

Particularly, it shall be noted that this amplifier 300 is an open-loop one and can be preferably used for audio applications.

Furthermore, the class-D amplifier 300 comprises a power supply terminal connectable to a power supply potential $V_A$, provided for example, by a battery, and a ground terminal to be connected to a ground potential GND.

This amplifier 300 comprises a comparing circuit or comparator 302 which can be schematically illustrated by means of an operational device provided with differential inputs.

Particularly, the comparator 302 comprises first differential input terminals S+ and S- in order to receive an input voltage differential signal $v_{in}(t)$, for example, a substantially sinusoidal signal of the audio type having peak-to-peak amplitude equal to $2V_{in}$. Moreover, second differential input terminals T+ and T- of the comparator 302 can be connected to a generation device 307 of a triangular wave signal $v_{tri}(t)$.

It shall be noted that the operational device of the comparator 302 can be provided by connecting in cascade two or more amplifying stages. For example, the comparator 302 comprises three amplifying stages (not shown in Fig. 2) of which: a first stage is provided with two differential inputs and one differential output; a second stage comprises differential input and output; a third stage is provided with one differential input and is single ended. These stages are provided by means of circuit structures known to those skilled in the art.

Furthermore, the generation device 307 is provided with differential output terminals. Particularly, the device 307 comprises a first OUT1 and second OUT2 output terminals connected to the terminals T+ and T- of the comparator 302, respectively, in order to give the latter the triangular signal $v_{tri}(t)$ of peak-to-peak amplitude equal to $2V_{tri}$.

Moreover, it shall be noted that the triangular signal $v_{tri}(t)$ generated by the device 307 has a frequency which is much higher than the one of the input signal $v_{in}(t)$, as it is known.

As it is known to those skilled in the art, an intermediate signal $V_{int}(t)$ is generated at an output terminal $C_o$ of the comparator 302 as consequence of the comparison between the input differential signal $v_{in}(t)$ and the triangular signal $v_{tri}(t)$.

Particularly, this intermediate signal $v_{int}(t)$ is a signal of the Pulse Width Modulation- or PWM-type of the known type, i.e. the intermediate signal $v_{int}(t)$ is a variable duty-cycle rectangular wave.

Furthermore, the amplifier 300 comprises a power stage 300' connected to the output terminal $C_o$ of said comparator 302.

Particularly, this power stage 300' comprises a class-D output stage 303 provided with a plurality of inputs.

Furthermore, the power stage 300' comprises a driving circuit 304 of the output stage 303. Said driving circuit 304 is of the known type. This driving circuit 304 can be connected between the comparator 302 and the same output stage 303 in order to give first NR, PR and second NL, PL activation signals to the inputs of the latter.

In other words, the driving circuit 304 is such as to carry out a processing of the PWM intermediate signal $v_{int}(t)$ in order to send said activation signals to the output stage 303.

Moreover, the output stage 303 comprises a third OP1 and fourth OP2 output terminals connected to a low-pass filter 305 of the LC-type. This filter 305 is connected to a user load 306 illustrated in Fig. 2, for example, by a loudspeaker.

As it is known, the filter 305 allows to send only a low-frequency component of the output-amplified audio signal from the stage 303 to the loudspeaker 306, thus eliminating the noise components at the higher frequencies.

For example, a circuit diagram of the class-D output stage 303 is illustrated in Fig. 4.

This output stage 303 comprises a first 303' and a second 303" devices of the inverting type, each of which is connected between the power supply potential $V_A$ and the ground potential GND. Moreover, this first inverting device 303' comprises first MN1 (N-MOS) and MP1 (P-MOS) transistors connected to one another by means of their respective drain terminals. Similarly, the second inverting device 303" comprises second MN2 (N-MOS) and MP2 (P-MOS) transistors connected to one another through their respective drain terminals.

Particularly, it shall be noted that the drain terminals of these first MN1, MP1 and second MN2, MP2 transistors correspond to the third OP1 and fourth OP2 output terminals of the stage 303, respectively.

It shall be noted that the gate terminals of said first MN1, MP1 and second MN2, MP2 transistors represent the inputs of the output stage 303.

These first MN1, MP1 transistors of the output stage 303 can be either ON- or OFF-controlled by means of their respective first NR and PR activation signals generated by the driving circuit 304. Similarly, the second MN2, MP2 transistors can be either ON- or OFF-controlled by means of their respective second NL and PL activation signals.

Particularly, it shall be noted that the first NR, PR and second NL, PL activation signals are signals of the digital type, i.e. they may only take two different values corresponding to two different logic levels: a logic high (for example, equal to the power supply potential $V_A$) and a logic low (for example, equal to the ground potential GND) .

In operative conditions, the first NR and PR activation signals always take similar values, thereby if one between the first MN1, MP1 transistors is ON, the other one is OFF. Similar considerations are valid for the second NL, PL signals and for their respective second MN2, MP2 transistors.

Furthermore, it shall be noted that the values taken by the first NR, PR and second NL, PL signals are such that the first P-MOS MP1 transistor and the second N-MOS MN2 transistor conduct simultaneously and, on the other hand, the first N-MOS MN1 transistor and the second P-MOS MP2 transistor conduct simultaneously. Moreover, the driving circuit 304 ensures an adequate phase displacement of said first NR, PR activation signals as well as of the second NL, PL ones. Thereby, the simultaneous ON state (ON-state overlap) of both the first MN1, MP1 transistors (or of both the second MN2, MP2 ones) is avoided, thus ensuring a high efficiency of the amplifier 300.

As it is known to those skilled in the art, the class-D amplifier 300 is of the binary type, i.e. a differential output signal $v_{out}$ (t) picked up from the output terminals OP1 and OP2 may only take two possible values, for example $+V_A$ and $-V_A$, for any (either positive or negative) value of the input signal $v_{in}(t)$.

A circuit block diagram of a further open-loop class-D amplifier 400 in accordance with the invention is shown in Fig. 3.

Preferably, this further amplifier 400 can be used in audio applications. Moreover, circuit components of the amplifier 400 either equal or similar to the ones introduced with reference to the amplifier 300 from Fig. 2 have been indicated in Fig. 3 with the same reference numbers.

It shall be noted that this amplifier 400 comprises a further power supply terminal connectable to the power supply potential $V_A$ and a further ground terminal connectable to the ground potential GND.

Particularly, this class-D amplifier 400 comprises two comparators 302, each of which is provided with two differential inputs. These comparators 302 have their respective first differential input terminals S+ and S- connected in parallel to each other in order to receive the input voltage differential signal $v_{in}$ (t) (for example, a sinusoidal signal of the audio type). Particularly, it shall be noted that these first differential terminals S+ and S- of the comparators 302 are connected to each other in an inverted manner, i.e. the first positive terminal S+ of one of the comparators is connected to the first negative terminal S- of the other one and vice versa.

Furthermore, the second differential input terminals T+ and T- of said comparators 302 are connected in parallel to each other and are connected to the differential output terminals OUT1 and OUT2 of the generation device 307 of the triangular signal $v_{tri}(t)$.

It shall be noted that the comparators 302 are such as to generate two different intermediate signals of the PWM-type, i.e. a first $v1_{int}$ (t) and second $v2_{int}$ (t) intermediate signals. These first $v1_{int}$ (t) and second $v2_{int}$ (t) intermediate signals are sent to a further power stage 400'.

This further power stage 400' comprises the four-input output stage 303 (shown in detail in Fig. 4) in order to give the amplified audio signal to the loudspeaker 306 through the differential output terminals OP1 and OP2.

In addition, the power stage 400' comprises a first 404 and second 404' driving circuits of the known type. Each driving circuit 404 and 404' can be connected to the output of one of the comparators 302.

Moreover, the first driving circuit 404 is suitable to generate the first NR and PR activation signals to be given to the output stage 303, from the first PWM intermediate signal $v1_{int}$ (t) received by its respective comparator 302. Similarly, the second driving circuit 404' is suitable to generate the second NL and PL activation signals to be given to the output stage 303 from the second intermediate signal $v2_{int}$ (t).

It shall be noted that the further class-D amplifier 400 is of the ternary type. In fact, the differential output signal $v_{out}$ (t) being present on the output terminals OP1 and OP2 may take three possible values $+V_A$, 0, and $-V_A$, through the first $v1_{int}$ (t) and second $v2_{int}$ (t) PWM intermediate signal. Particularly, the output signal $v_{out}$ (t) may vary between $+V_A$ and 0 for positive values of the input signal $v_{in}$ (t), whereas this signal $V_{out}$ (t) takes values between 0 and $-V_A$, for negative values of the same input signal vin (t).

Consequently, the output audio signal $v_{out}$ (t) generated from the ternary amplifier 400 is nearly zero, for low levels of the input audio signal $v_{in}$ (t). Therefore, the spectrum of this output signal $V_{out}$ (t) has a base-band fundamental component, whereas the further frequency components are insignificant and, in any case, they are at higher frequencies such as not to interfere with said fundamental component. Therefore, the filtering of these high-frequency components is not required, as it occurs, on the contrary, for the binary amplifier 300.

An example of a generation device 307 of the triangular signal $v_{tri}$ (t) usable in the class-D amplifiers of the binary 300 and ternary 400 types of the invention can be described with reference to Figs. 5 and 6.

Advantageously, it shall be noted that this generation device 307 can be integrated on a semiconductor chip on which all the electronic components forming the circuit structure of the binary 300 (or the ternary 400) amplifier are integrated.

Therefore, the circuit elements of the generation device 307 are advantageously manufactured during the same steps of the manufacturing process of all the other electronic components of the amplifiers 300 and 400. Accordingly, the same process tolerance is ensured with all the electronic components of the amplifiers.

Moreover, the class-D amplifiers 300 and 400 of the invention do not have to use an external triangle generator, therefore these amplifiers have a compact structure and ensure a reduced overall size.

With reference to Fig. 5, the generation device 307 of the triangular signal $v_{tri}$ (t) comprises an integrating circuit or integrator 501 provided by means of a feedback operational amplifier 502.

It shall be noted that the operational amplifier 502 comprises polarization terminals connectable between the power supply potential $V_A$ and the ground potential GND.

Furthermore, it shall be noted that this operational amplifier 502 is provided with input and output terminals of the differential type. Particularly, the operational amplifier 502 comprises the first OUT1 and second OUT2 output terminals described above with reference to Fig. 2.

This first OUT1 output terminal of the operational amplifier 502 can be connected to a further first IN1 input terminal by means of a first feedback electric network 503. Similarly, the second OUT2 output terminal can be connected to a further second IN2 input terminal by means of a second feedback electric network 503'. This first/second feedback electric network 503/503' comprises a first/second resistance $R_1/R_1$' connected in parallel to a first/second capacitor C/C'.

Particularly, the resistances $R_1$ and $R_1$' are equal to each other, i.e. $R_1=R_1$'. Moreover, the capacitors C and C' are also equal to each other and have a capacitance value which can be adjusted by means of a plurality of digital signals REG0, REG1, ..., REGN.

Particularly, it shall be noted that each of said first C and second C' capacitors includes a plurality of capacitors connectable in parallel to one another based on the binary levels (0 and 1) of these digital signals.

In addition, it shall be noted that the operational amplifier 502 is also provided with a common-mode input terminal CM, being generally fixed to the potential $V_A/2$.

The generation device 307 further comprises a plurality of electronic switches which can be alternatively activated and deactivated in order to connect said further first IN1 and further second IN2 input terminals either to the power supply potential $V_A$ or the ground potential GND.

Particularly, the device 307 comprises a first pass-transistor $T_1$, for example of the N-MOS-type, having the source terminal connected to the further first IN1 input terminal and the drain terminal connected to the power supply potential $V_A$ by means of a third resistance $R_2$. Moreover, a second pass-transistor $T_2$, of the N-MOS-type, has the drain terminal connected to the further second IN2 input terminal and the source terminal connected to the ground potential through a fourth resistance $R_2$'. These third $R_2$ and fourth $R_2$' resistances are equal to each other, i.e. $R_2=R_2$'.

In addition, a third N-MOS pass-transistor $T_3$ of the generation device 307 has the drain terminal connected to the first IN1 input terminal and the source terminal connected to the ground potential through the fourth resistance $R_2$'. On the other hand, a fourth N-MOS pass-transistor $T_4$ has the source terminal connected to the second IN2 input terminal and the drain terminal connected to the power supply potential $V_A$ through said third resistance $R_2$.

Particularly, it shall be noted that the gate terminals of the first $T_1$ and second $T_2$ pass-transistors can be controlled by means of a first digital signal $S_1$, whereas the gate terminals of the third $T_3$ and fourth $T_4$ pass-transistors can be controlled by means of a second digital signal $S_2$. These digital signals $S_1$ and $S_2$ may take two different logic levels (0 and 1) and are generated by a logic circuit 600 being schematically illustrated in Fig. 6.

This logic circuit 600 comprises a first 601 and second 602 two-input digital gates NAND. Particularly, both the digital gates NAND 601 and 602 are suitable to receive a start signal STR for generating the triangular signal $v_{tri}$ (t), at one of the inputs. On the other hand, a timing digital signal or clock signal CK can be applied to the other input of said gates. Particularly, such as shown in Fig. 6, the clock signal CK can be directly applied to the first gate NAND 601, whereas the second gate NAND 602 receives the opposite of this digital signal CK generated by a first inverter 604.

For example, the clock signal CK is a pulse train having a constant frequency $f_{ck}$ and duty cycle of 50%, i.e. the signal CK takes a high level for a half cycle and a low level for the subsequent half cycle.

Moreover, the digital signals $S_1$ and $S_2$ controlling the gate terminals of the pass-transistors $T_1$, $T_2$, $T_3$, and $T_4$ of the generation device 307 are obtained by inverting the output digital signals from the gates NAND 601 and 602 by means of their respective output inverters 603.

It shall be noted that, following the activation of the logic circuit 600 by means of the logic high start signal STR (logic 1), the digital signals $S_1$ and $S_2$ generated by this circuit in response to the external clock signal CK take different logic levels in each half cycle of the clock signal CK. For example, in the half cycle where the clock signal CK is of a logic high (logic 1), the first digital signal $S_1$ is a logic 1, whereas the second digital signal $S_2$ is a logic 0.

On the other hand, in the subsequent half cycle where the clock signal CK has a logic low (logic 0), the first digital signal $S_1$ is a logic 0 and the second digital signal $S_2$ is a logic 1.

With the first logic high signal $S_1$ and second logic low signal $S_2$, the first $T_1$ and second $T_2$ pass-transistors of the generation device 307 are ON, whereas the third $T_3$ and fourth $T_4$ are OFF.

Therefore, a constant current equal to $V_A/2R_2$ charges the first capacitor C, whereas an equal current, but of an opposite direction, discharges the second capacitor C'.

Thereby, with reference to the potential of the common-mode terminal CM, the potential of the first OUT1 output terminal decreases, whereas the potential of the second OUT2 output terminal increases.

On the other hand, with the first low-level signal $S_1$ and second high-level signal $S_2$, the third $T_3$ and fourth $T_4$

pass-transistors of the generation device 307 are ON, whereas the first $T_1$ and second $T_2$ are OFF.

Accordingly, the same constant current equal to $V_A/2R_2$ charges the second capacitor C' and an equal current, but of an opposite direction, discharges the first capacitor C.

Thereby, the potential of the first OUT1 output terminal increases, whereas the potential of the second OUT2 output terminal decreases.

It shall be noted that for subsequent cycles of the clock signal CK, triangular signals $v_1$ and $v_2$ are generated at the output terminals OUT1 and OUT2 of the generation device 307, each of which is obtained by alternating upward and downward slopes of the potential of the output terminals OUT1 and OUT2.

It shall be noted that these triangular signals $v_1$ and $v_2$ are in phase opposition to each other. Moreover, these signals $v_1$ and $v_2$ have peak-to-peak amplitude equal to $V_{tri}$ and a same frequency $f_{tri}$.

Accordingly, the triangular signal $v_{tri}(t)$ of peak-to-peak amplitude $2V_{tri}$ produced by the generation device 307 can be obtained by picking up the differential signal from these terminals OUT1 and OUT2. This differential signal $v_{tri} = v_1 - v_2$ and has a frequency equal to $f_{tri}$.

Advantageously, the generation device 307 is such as to generate a triangular signal $v_{tri}(t)$ in which a triangular wave slope changes when each half cycle of the external clock signal CK having a constant frequency $f_{ck}$ ends. In other words, the duration of each half cycle of the triangular wave $v_{tri}(t)$ is substantially equal to the duration of a half cycle of the clock signal CK, therefore the frequency $f_{tri}$ of the triangular signal $v_{tri}$ is substantially equal to the frequency $f_{ck}$ of this clock signal CK.

On the other hand, the peak value $V_{tri}$ of the triangular signal $v_{tri}(t)$ generated by the device 307 can be expressed as:

$$V_{tri} = \frac{V_A}{4R_2C} * \frac{1}{f_{tri}} \qquad (1)$$

From formula (1) it follows that the peak value $V_{tri}$ of the triangular wave may vary following changes in the power supply potential $V_A$. Moreover, this peak value $V_{tri}$ may also change as a function of the product $R_2C$ and, in the latter case, this change may also be of 40% with process and temperature.

In order to overcome this drawback, there is provided the use of a control circuit of the known type (not shown in the figures) such as, for example, the control circuit described in the document "Analog front-end IC for 3G WCDA, T. Y. Chang et al., Digest of Technical Papers on 2002 IEEE Symposium on VLSI Circuits, Fig. 7".

Particularly, this control circuit operates in order to provide the above-mentioned control digital signals REGO, REG1, ..., REGN for varying the capacitance value of the first C and second C' capacitors.

Thereby, the numerical value of the product $R_2C$ is made proportional to a cycle $T_{ck}$ of the clock signal CK, i.e.:

$$R_2 * C = k * T_{ck} \qquad (2)$$

wherein k is a proportionality constant.

Thereby, the expression (1) becomes:

$$V_{tri} = \frac{V_A}{4R_2C} * \frac{1}{f_{tri}} = \frac{V_A}{4 * k * T_{ck}} * T_{ck} = \frac{V_A}{4 * k} \qquad (3)$$

therefore, the peak value $V_{tri}$ of the triangular signal $v_{tri}(t)$ only changes as a function of the power supply potential $V_A$.

As it is known to those skilled in the art, a gain $G_1$ of the open-loop amplifiers 300 and 400 of the invention can be expressed as:

$$G_1 = \frac{V_A}{V_{tri}} \qquad (4)$$

wherein $V_{tri}$ is the peak value of the triangular signal $v_{tri}$ (t).

Advantageously, this gain G1 is constant and stable given that with the generation device 307 the peak value $V_{tri}$ only depends on changes in the power supply potential $V_A$ in accordance with (3).

Furthermore, the generation device 307 of the triangular signal $v_{tri}$ (t) also ensures an accurate upward and downward slope linearity of the triangular signal $v_{tri}$ (t).

In addition, it has been verified that the amplifiers of the invention ensure a high Power Supply Rejection, i.e. a high PSRR by using the comparators 302 having two differential inputs and the generation device 307 with a differential output.

Finally, it shall be noted that the open-loop amplifier 300 of the invention has a static power consumption which is lower than the corresponding closed-loop amplifier because the latter provides an input integrator, therefore it includes one more operational device. For this reason, the low-level efficiency of the open-loop amplifier is higher than that of the closed-loop amplifier.

Obviously, to the audio amplifiers of the present invention, those skilled in the art, aiming at satisfying contingent and specific needs, will be able to carry out further modifications and variants, all of them being contemplated within the scope of protection of the invention, such as defined in the claims below.

**Claims**

1. An open-loop class-D amplifier (300; 400), comprising:

    - a generation device (307) of a triangular wave signal ($v_{tri}$ (t));
    - at least one comparing circuit (302) provided with a first input terminal (S+, S-) in order to receive a first signal ($v_{in}$ (t)) and a second input terminal (T+, T-) in order to receive the triangular signal generated by said generation device, the comparing circuit producing an output intermediate signal ($v_{int}$ (t); $v1_{int}$ (t)) in response to the comparison of said first signal and the triangular signal with each other;
    - a power stage (300'; 400') in order to give a load (306) an output signal ($v_{out}$ (t)) dependent on the intermediate signal;
    - a terminal connectable to a power supply potential ($V_A$);

    **characterized in that** said generation device is such that the triangular signal has a peak value ($V_{tri}$) which is substantially proportional to said power supply potential ($V_A$) and a frequency ($f_{tri}$) which is fixed to a reference frequency value ($f_{ck}$), for the power supply potential changes.

2. The class-D amplifier (300; 400) according to claim 1, wherein said first input terminal (S+, S-) of said at least one comparing circuit (302) comprises two first differential input terminals and said second input terminal (T+, T-) comprises two second differential input terminals.

3. The class-D amplifier (300; 400) according to claim 2, wherein said at least one comparing circuit (302) comprises an operational amplifier which can be provided by connecting in cascade a multiplicity of amplifying stages.

4. The class-D amplifier (300; 400) according to claim 2, wherein said generation device (307) comprises an integrating circuit (501) provided with a first (OUT1) and second (OUT2) differential output terminals connectable to said second (T+, T-) input terminals in order to give the triangular signal ($v_{tri}$ (t)) to the at least one comparing circuit (302).

5. The class-D amplifier (300; 400) according to claim 4, wherein said integrating circuit (501) of the generation device (307) further comprises:

    - a further first input terminal (IN1) electrically connectable to the power supply potential ($V_A$) and a ground potential by means of a first ($T_1$) and third ($T_3$) electronic switches, respectively;
    - a further second input terminal (IN2) electrically connectable to the power supply potential ($V_A$) and the ground potential by means of a fourth ($T_4$) and second ($T_2$) electronic switches, respectively;

    said first and second electronic switches being capable of being simultaneously activated in order to generate an upward slope of the triangular signal ($v_{tri}$ (t)) being present on said first (OUT1) and second (OUT2) differential output terminals; said third and fourth electronic switches being capable of being simultaneously activated in order to generate a downward slope of the triangular signal being present on said first (OUT1) and second (OUT2) differential output terminals.

**6.** The class-D amplifier (300; 400) according to claim 5, wherein said first ($T_1$) and second ($T_2$) electronic switches can be activated/deactivated by means of a first digital signal ($S_1$) and wherein said third ($T_3$) and fourth ($T_4$) switches can be activated/deactivated by means of a second digital signal ($S_2$).

**7.** The class-D amplifier (300; 400) according to claim 6, wherein said first ($S_1$) and second ($S_2$) digital signals are generated by means of a logic circuit (600) in response to an external timing signal (CK) having a constant frequency equal to said reference frequency ($f_{ck}$) .

**8.** The class-D amplifier (300; 400) according to claim 7, wherein these first ($S_1$) and second ($S_2$) digital signals take different logic levels in each half cycle of the timing signal (CK) in order to generate upward slopes of the triangular signal ($v_{tri}(t)$) alternated to downward slopes in subsequent half cycles.

**9.** The class-D amplifier (300; 400) according to claim 5, wherein said electronic switches are N-MOS pass-transistors.

**10.** The class-D amplifier (300; 400) according to claim 5, wherein said first (OUT1)/second (OUT2) output terminal of the integrating circuit (501) can be connected to the further first (IN1)/second (IN2) input terminal by means of a first (503)/a second (503') feedback electric network.

**11.** The class-D amplifier (300; 400) according to claim 10, wherein each of these first (503) and second (503') electric networks comprises a resistance ($R_1$, $R_1'$) connected in parallel to a capacitor (C, C') the capacitance value of which can be adjusted by means of a plurality of digital signals (REGO, REG1, ..., REGN).

**12.** The class-D amplifier (300; 400) according to claim 11, wherein the peak value ($V_{tri}$) of the triangular signal ($v_{tri}(t)$) can be expressed as:

$$V_{tri} = \frac{V_A}{4R_2C} * \frac{1}{f_{tri}}$$

wherein the numerical value of the product $R_2C$ is made proportional to a cycle ($T_{ck}$) of the timing signal (CK) by means of a control circuit suitable to provide the above-mentioned digital signals (REGO, REG1, ..., REGN) in order to make the peak value ($V_{tri}$) of the triangular signal ($v_{tri}(t)$) substantially proportional to the power supply potential ($V_A$) according to the expression

$$V_{tri} = \frac{V_A}{4R_2C} * \frac{1}{f_{tri}} = \frac{V_A}{4*k*T_{ck}} * T_{ck} = \frac{V_A}{4*k}$$

**13.** The class-D amplifier (300; 400) according to claim 12, the gain ($G_1$) of which is given by the ratio of the power supply potential ($V_A$) to the peak value ($V_{tri}$) of the triangular signal ($v_{tri}(t)$) is constant and stable when said power supply potential changes.

**14.** The class-D amplifier (300; 400) according to claim 2, wherein said power stage (300'; 400') comprises a class-D output stage (303) controllable by means of at least one driving circuit (304; 404, 404') connected between the at least one comparing circuit (302) and said output stage.

**15.** The class-D amplifier (300; 400) according to claim 14, wherein said output stage (303) comprises first (MN1, MP1) and second (MN2, MP2) transistors activable/deactivable by means of first (NR, PR) and second (NL, PL) activation signals, respectively.

**16.** The class-D amplifier (300; 400) according to claim 15, wherein said first (NR, PR) and second (NL, PL) activation signals are generated by the at least one driving circuit (304; 404, 404') following a processing of the intermediate signal ($v_{int}(t)$ ; $v1_{int}(t)$).

**17.** The class-D amplifier (300; 400) according to claim 1 or 16, wherein said intermediate signal (Vint (t) $v1_{int}(t)$) is a Pulse Width Modulation signal.

18. The class-D amplifier (300) according to claim 14, comprising a single comparing circuit (302) output connected to a single driving circuit (304), the amplifier being of the binary type.

19. The class-D amplifier (400) according to claim 14, comprising two comparing circuits (302) having their respective outputs connected to two driving circuits (404, 404'), the amplifier being of the ternary type.

20. The class-D amplifier (300; 400) according to claim 1, wherein said generation device (307), said at least one comparing circuit (302), and said power stage (300', 400') are integrated on a same semiconductor chip.

108 109

$V_i$

$R_1$

$C_3$

$R_2$

105 106

101 107 102 104 103 100

**FIG.1**

$V_A$

PR —| MP1    MP2 |— PL

303' — OP1    OP2 — 303"

NR —| MN1    MN2 |— NL

GND

303    **FIG.4**

FIG.2

FIG.3

307

FIG. 5

600

FIG. 6

**European Patent Office**

**EUROPEAN SEARCH REPORT**

Application Number

EP 05 42 5811

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 820 940 A (WACHI ET AL) 11 April 1989 (1989-04-11) | 1,17,20 | H03F3/217 |
| A | * column 4, line 24 - column 7, line 50; figures 3,4A,4B,4C,4D * | 2-16,18, 19 | |
| X | US 5 014 016 A (ANDERSON ET AL) 7 May 1991 (1991-05-07) | 1,17,20 | |
| A | * column 4, lines 52-68; figure 3 * | 2-16,18, 19 | |
| X | US 2004/232979 A1 (EDWARDS CHRISTOPHER FRANCIS ET AL) 25 November 2004 (2004-11-25) | 1,17,20 | |
| A | * paragraphs [0014] - [0029]; figure 1 * | 2-16,18, 19 | |
| X | US 2005/156665 A1 (MAEJIMA TOSHIO) 21 July 2005 (2005-07-21) | 1,17,20 | |
| A | * the whole document * | 2-16,18, 19 | |
| A | DE 102 28 575 A1 (INFINEON TECHNOLOGIES AG) 29 January 2004 (2004-01-29) * paragraphs [0024] - [0028]; figure 1 * | 1-20 | TECHNICAL FIELDS SEARCHED (IPC) H03F |

The present search report has been drawn up for all claims

| Place of search | Date of completion of the search | Examiner |
|---|---|---|
| The Hague | 23 February 2006 | Fedi, G |

**EP 1 788 701 A1**

## ANNEX TO THE EUROPEAN SEARCH REPORT
## ON EUROPEAN PATENT APPLICATION NO.

EP 05 42 5811

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2006

| Patent document cited in search report | | Publication date | Patent family member(s) | | Publication date |
|---|---|---|---|---|---|
| US 4820940 | A | 11-04-1989 | AU 568731 B2 | | 07-01-1988 |
| | | | AU 4066085 A | | 11-10-1985 |
| | | | DE 3582406 D1 | | 08-05-1991 |
| | | | EP 0183849 A1 | | 11-06-1986 |
| | | | JP 60190010 A | | 27-09-1985 |
| | | | WO 8504293 A1 | | 26-09-1985 |
| | | | KR 9000481 B1 | | 30-01-1990 |
| US 5014016 | A | 07-05-1991 | CA 2013727 A1 | | 13-10-1990 |
| | | | DE 4011610 A1 | | 18-10-1990 |
| | | | FR 2646031 A1 | | 19-10-1990 |
| | | | IT 1239633 B | | 11-11-1993 |
| | | | JP 2288710 A | | 28-11-1990 |
| US 2004232979 | A1 | 25-11-2004 | WO 2004107564 A1 | | 09-12-2004 |
| US 2005156665 | A1 | 21-07-2005 | NONE | | |
| DE 10228575 | A1 | 29-01-2004 | NONE | | |

EPO FORM P0459